# EUROPEAN PATENT APPLICATION

(11) **EP 4 791 136 A1**
(43) Date of publication of application: **12.08.2026**
(21) Application number: 26157363.8
(22) Date of filing: 09.02.2026
(51) Int. Cl.: H05K 7/20

(54) **FLOW BOILING DIRECT TO CHIP HEAT SINK**

(30) Priority: 11.02.2025 US 202563757131 P
(71) Applicant: Carrier Corporation, Palm Beach Gardens, FL 33418 (US)
(72) Inventor: JOARDAR, Arindom, East Syracuse, NY, 13057 (US); MOHANTA, Lokanath, East Syracuse, NY, 13057 (US); GHAZVINI, Mahyar, East Syracuse, NY, 13057 (US)
(74) Representative: Dehns

(57) **Abstract**

A cooling device (100) associable with a heat-generating electronic device (50) of a server (30) includes a housing (120) having a fluid inlet (122) and a fluid outlet (124) and a divider (126) separating the interior of the housing into a first fluid compartment (128) and a second fluid compartment (130). Both the first fluid compartment (128) and the second fluid compartment (130) are fluidly connected to the fluid inlet (122). A heat transfer potential of the second fluid compartment (130) is less than the heat transfer potential of the first fluid compartment (128). At least one opening (140a, 140b) is formed in the divider (126) at a location downstream from the fluid inlet (122) and upstream from the fluid outlet (124). The first fluid compartment (128) is fluidly coupled to the second fluid compartment (130) at the at least one opening (140a, 140b).

## Description

### BACKGROUND

Exemplary embodiments pertain to the art of thermal management, and more particularly, relate to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating devices mounted thereto. The printed circuit boards are commonly housed in an enclosure having vents configured to direct external air from the data center into, through and out of the enclosure. The air absorbs heat dissipated by the components and after being exhausting from the enclosure, mixes with the ambient air. An air conditioner is then used to cool the heated air of the data center and to recirculate it, repeating the cooling process.

Higher performance server components typically dissipate more power. However, the amount of heat that conventional cooling device can remove from a server is limited. Due to the small length of a fluid flow path through a conventional cooling device and a high vapor flow rate relative to the liquid phase flow of the cooling fluid, it can be difficult to prevent dryout at or upstream from an outlet of the cooling device. Dryout is when the liquid portion of the cooling fluid evaporates causing vaporized cooling fluid to directly contact a heat transfer surface. This direct contact between the heat transfer surface and the vapor results in a rapid decrease in heat flux and results in declining heat transfer performance.

### BRIEF DESCRIPTION

According to a first aspect of the invention, there is provided a cooling device associable with a heat-generating electronic device of a server, the cooling device includes a housing having a fluid inlet and a fluid outlet and a divider separating the interior of the housing into a first fluid compartment and a second fluid compartment. Both the first fluid compartment and the second fluid compartment are fluidly connected to the fluid inlet. A heat transfer potential of the second fluid compartment is less than the heat transfer potential of the first fluid compartment. At least one opening is formed in the divider at a location downstream from the fluid inlet and upstream from the fluid outlet. The first fluid compartment is fluidly coupled to the second fluid compartment at the at least one opening.

Optionally, the divider is formed from a material having a low coefficient of thermal conductivity.

Optionally, the cooling device comprises a diverter arranged within the fluid inlet to separate a cooling fluid at the fluid inlet into a first stream of cooling fluid and a second stream of cooling fluid. The first stream of cooling fluid may be receivable within the first fluid compartment and the second stream of cooling fluid may be receivable within the second fluid compartment.

Optionally, the cooling device comprises a valve arranged within the fluid inlet to separate a cooling fluid at the fluid inlet into a first stream of cooling fluid and a second stream of cooling fluid. The first stream of cooling fluid may be receivable within the first fluid compartment and the second stream of cooling fluid may be receivable within the second fluid compartment.

Optionally, the first fluid compartment is directly fluidly connected to the fluid outlet.

Optionally, the second fluid compartment is directly fluidly connected to the fluid outlet via a bypass and only a portion of a cooling fluid within the second fluid compartment is receivable within the bypass.

Optionally, the second fluid compartment is configured as a liquid-vapor separator to separate the cooling fluid into vapor cooling fluid and liquid cooling fluid and the bypass is positioned to receive only the vapor cooling fluid.

Optionally, the at least one opening includes a plurality of openings arranged at a plurality of positions along a length of the divider between the fluid inlet and the fluid outlet.

Optionally, the plurality of positions includes a first position and a second position. A first portion of the plurality of openings may be arranged at the first position and a second portion of the plurality of openings may be arranged at the second position. A configuration of the first portion of the plurality of openings may be different than the configuration of the second portion of the plurality of openings.

Optionally, the at least one opening includes an opening aligned with a hot spot of the heat-generating electronic device.

Optionally, the housing is indirectly thermally couplable to the heat-generating electronic device by a heat spreader.

Optionally, the heat spreader is positionable vertically between the heat-generating electronic device and the cooling device.

According to a second aspect of the invention there is provided a method of cooling a heat-generating electronic device of a server, the method includes delivering a flow of cooling fluid to a fluid inlet of a cooling device, separating the flow of cooling fluid into a first stream of cooling fluid provided to a first fluid compartment within the cooling device and a second stream of cooling fluid provided to a second fluid compartment within the cooling device, transferring heat between the heat-generating electronic device and the first stream of cooling fluid, and selectively injecting cooling fluid from the second stream of cooling fluid into the first stream of cooling fluid in the first fluid compartment at a location upstream from a fluid outlet of the cooling device.

Optionally, the selectively injecting cooling fluid from the second stream of cooling fluid into the first stream of cooling fluid includes injecting cooling fluid from the second stream of cooling fluid through one or more openings formed in a divider separating the first fluid compartment and the second fluid compartment.

Optionally, the divider is formed from a material having a low coefficient of thermal conductivity.

Optionally, the selectively injecting cooling fluid from the second stream of cooling fluid into the first stream of cooling fluid includes injecting a first portion of the second stream of cooling fluid into the first stream of cooling fluid at a first location within the cooling device and injecting a second portion of the second stream of cooling fluid into the first stream of cooling fluid at a second location within the cooling device. The second location may be downstream from the first location relative to the flow of cooling fluid through the cooling device.

Optionally, the separating the flow of cooling fluid into the first stream of cooling fluid and the second stream of cooling fluid includes positioning a diverter within the fluid inlet.

Optionally, the separating the flow of cooling fluid into the first stream of cooling fluid and the second stream of cooling fluid includes operating a valve associated with the fluid inlet.

Optionally, separating the second stream of cooling fluid into a vapor portion and a liquid portion and delivering the vapor portion directly to the fluid outlet via a bypass fluidly connected to the second fluid compartment.

According to a third aspect of the invention there is provided a server, the server includes a heat-generating electronic device and a cooling device thermally coupled to the heat-generating electronic device. The cooling device includes a housing having a fluid inlet and a fluid outlet and a divider separating the interior of the housing into a first fluid compartment and a second fluid compartment. Both the first fluid compartment and the second fluid compartment are fluidly connected to the fluid inlet. A heat transfer potential of the second fluid compartment is less than the heat transfer potential of the first fluid compartment. At least one opening is formed in the divider at a location downstream from the fluid inlet and upstream from the fluid outlet. The first fluid compartment is fluidly coupled to the second fluid compartment at the at least one opening.

### BRIEF DESCRIPTION OF THE DRAWINGS

The following descriptions should not be considered limiting in any way. With reference to the accompanying drawings, like elements are numbered alike:
FIG. 1 is a front view of a data center rack having a plurality of servers mounted therein;
FIG. 2A is a perspective view of a server;
FIG. 2B is a cross-sectional side view of a server;
FIG. 3 is a schematic view of a cooling module device to a heat-generating electronic device;
FIG. 4 is a schematic diagram of a heat sink having a fluid flow path formed therein; and
FIG. 5 is a schematic diagram of a heat sink having another fluid flow path formed therein.

### DETAILED DESCRIPTION

A detailed description of one or more embodiments of the disclosed apparatus and method are presented herein by way of exemplification and not limitation with reference to the Figures.

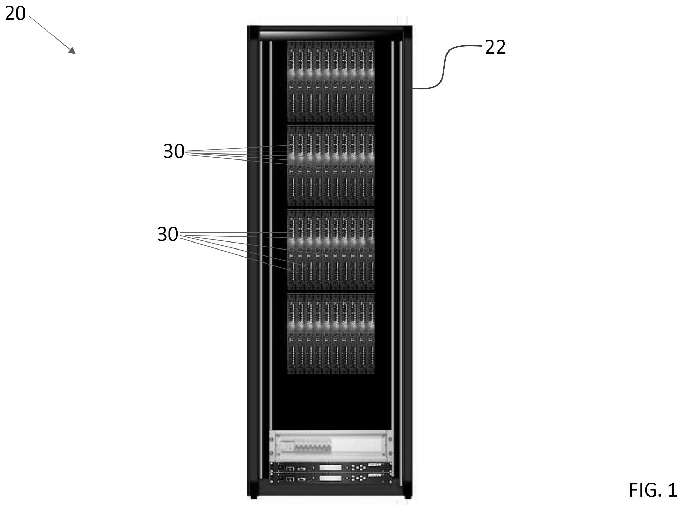

With reference now to FIG. 1, an example of a data center 20 is illustrated. As shown, the data center 20 includes a cabinet 22 having at least one, and in some embodiments, a plurality of slots (not shown) formed therein. One or more server rack sub-assemblies, also referred to herein as servers 30 may be permanently or removably mountable within the cabinet 22, such as within the one or more slots formed therein. The plurality of slots, and therefore the at least one server 30 receivable therein, may have a generally vertical orientation (shown), or alternatively, may have a horizontal orientation. In some embodiments, the data center 20 may include a combination of both horizontally oriented and vertically oriented slots. Further, although only a single cabinet 22 is illustrated in the FIG., it should be appreciated that the data center 20 may include several cabinets 22. In embodiments including a plurality of cabinets 22, the plurality of cabinets 22 may be arranged at the same location within a building, or alternatively, one or more of the cabinets 22 may be arranged at a different location within a single building or within multiple buildings.

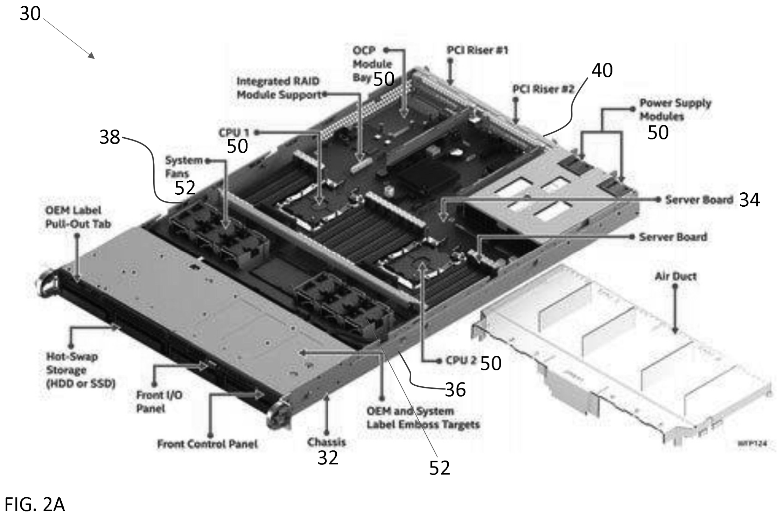

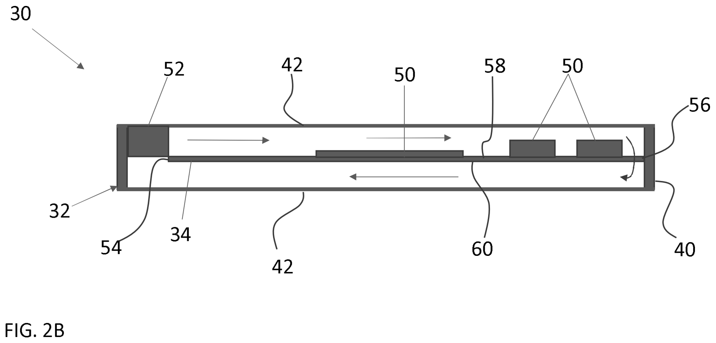

With reference now to FIG. 2, an example of a server 30 receivable within a slot of the cabinet 22 is illustrated. As shown, the server 30 may include a frame or chassis 32 having at least one printed circuit board 34 mounted to the frame. Although only a single printed circuit board 34 is illustrated in the FIG., it should be understood that in some embodiments, a plurality of printed circuit boards may be mounted to the chassis 32. The chassis 32 is designed to be insertable, for example slidably insertable, into a slot of a server rack and allow for connection to power cables, data cables, and/or other connecting cables provided at or by the cabinet 22.

The chassis 32 may include a plurality of walls 36, 38, 40 oriented at an angle to the printed circuit board 34 and that extend about all or at least a portion of a periphery of the printed circuit board 34. In an embodiment, best shown in FIG. 2B, the chassis 32 includes at least one flat, generally planar panel connected to one or more of the peripheral walls 36,38, 40 of the chassis 32. The at least one flat panel 42 may be arranged at either a first side or a second side of the printed circuit board 34. When the server 30 is in a horizontal orientation as shown, such a flat panel 42 may be vertically offset from the printed circuit board 34, either above or underneath the printed circuit board. In some embodiments, a flat panel 42 may be arranged both above and below the printed circuit board. In an embodiment, the chassis 32 in combination with the flat panels 42 form an air-tight container surrounding the server 30. However, embodiments where a separate jacket or container is positioned about the server 30 to form an air-tight assembly are also contemplated herein.

At least one heat-generating electronic device 50 may be mounted or electrically connected to the printed circuit board 34. Examples of a heat-generating electronic device 50 include but are not limited to a processor such as a central processing unit and/or graphics processing unit, memory, a hard drive, and a power supply module. A server 30 may also include one or more components that are not mounted to or are not electrically connected to the printed circuit board 34. In embodiments where the server 30 includes two or more of the same type of component, such as central processing units for example, the components may be aligned along an axis extending between the lateral sides 36, 38 of the chassis 32, may be aligned along an axis extending between the front and back of the chassis 32, or may be offset from one another in one or more directions. It should be appreciated that any heat-generating electronic device 50 may be located at any position within the chassis 32 or about the circuit board 34.

In some embodiments, one or more fluid movement devices 52, such as fans for example, are mounted to the printed circuit board 34 and are operable to move a flow of a fluid, such as air over the heat-generating electronic devices 50. In the illustrated, non-limiting embodiment, at least one fluid movement device 52 is arranged near a first end 54 of the printed circuit board 34 such that when the server 30 is installed within the cabinet 22, at least one fan 52 is positioned closer to the front of the cabinet 22 than the heat-generating electronic devices 50. However, embodiments where one or more fluid movement devices 52 are arranged at another suitable location, such as near a second end 56 of the printed circuit board 34 or of the chassis 32 associated with the rear of the cabinet 22 for example, are also within the scope of the disclosure. It should be appreciated that a server 30 having any suitable configuration, including servers having a full width or a half width or sled configuration are within the scope of the disclosure.

In an embodiment, the fluid moved by at least one fluid movement device 52 is configured to make a single pass over the heat-generating electronic devices. For example, cool air may be drawn into the fan 52 from a location adjacent to the front of the chassis 32 and after removing heat from the heat-generating electronic devices 50, may be exhausted at the back of the chassis 32. It should be appreciated that the air exhausted from the back of the cabinet may be the same temperature as the surrounding or environment, warmer than the surrounding environment, or even cooler than the surrounding environment. In other embodiments, such as where the chassis 32 includes at least one flat panel 42 for example, the fluid may be configured to continuously circulate within the server 30. For example, as best shown in FIG. 2B, a fan 52 may push the flow of fluid across the heat-generating electronic devices 50 arranged at a first surface 58 of the printed circuit board 34. Upon reaching the second end 56 of the printed circuit board 34, the fluid may turn through one or more openings and make a second pass along the second, opposite side 60 of the printed circuit board 34. Upon reaching the first end 54 of the printed circuit board 34, the fluid may turn again and be drawn back into an inlet of the at least one fan 52.

The heat generating devices of a server, such as server 30 for example, typically include one or more main heat generating devices and one or more peripheral heat generating devices. Examples of a main heat-generating electronic device include microchips, such as but not limited to central processing units (CPUs) or graphics processing units (GPUs). The term "peripheral heat-generating device" as used herein is intended to describe a heat-generating component that is a not a microchip. Peripheral heat generating devices may be described as other components of a server, such as a memory, hard drive, or power supply module. In an embodiment, a peripheral heat-generating electronic device generates less heat than a main heat-generating device when energized. For example, a peripheral heat-generating device may be configured to generate less than 25% of the heat of the server, and in some embodiments less than 20%, less than 19%, less than 18%, less than 17%, less than 16%, less than 15%, less than 14%, less than 13%, less than 12%, less than 11%, or less than 10%. However, it should be appreciated that any of the components of the server 30 may be designed as the at least one peripheral heat-generating electronic device and any of the components of the server 30 may be designed as a main heat-generating electronic device.

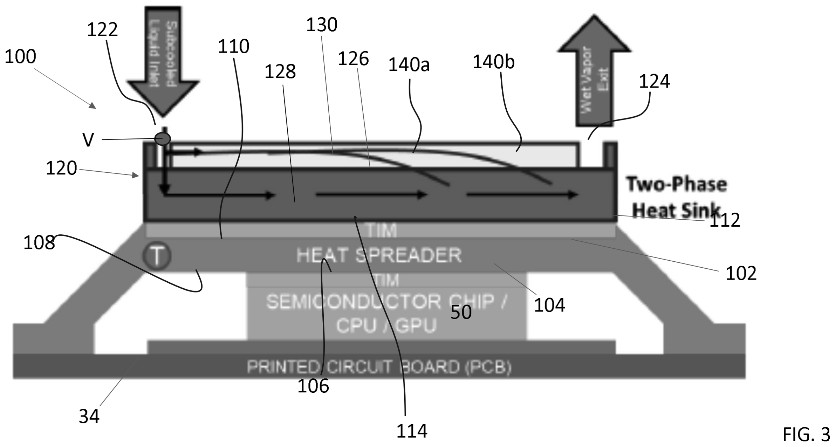

With reference now to FIG. 3, a cooling device 100 for removing heat from one or more of the heat-generating electronic devices 50 is illustrated according to an embodiment. As shown, the cooling device 100 may be mounted in axially overlapping relationship with and may be thermally coupled to a heat-generating electronic device 50 of a server 30. In some embodiments, the cooling device 100 is directly coupled to a surface of the heat-generating electronic device 50. However, in other embodiments, as shown in FIG. 3, the cooling device 100 may be indirectly coupled to a heat-generating electronic device 50. In server applications, the available surface area of most heat-generating electronic devices 50 (i.e., CPUs, GPUs, etc.,) is very small. Because the amount of heat to be dissipated from such a heat-generating electronic device 50 is typically very high, the surface area available to form an interface with the cooling device 100 is insufficient to meet the cooling demand of the heat-generating electronic device 50.

Accordingly, in the illustrated, non-limiting embodiment, a heat spreader 102, such as formed from a conductive material like sheet metal for example, is affixed to the printed circuit board 34 adjacent to the heat-generating electronic device 50. Although the heat spreader 102 is illustrated as axially overlapping both the heat-generating electronic device 50 and the printed circuit board 34, embodiments where the heat spreader 102 is arranged at another location relative to the heat-generating electronic device 50 are also contemplated herein.

A first thermal interface material 104, such as a thermal grease or thermal tape for example, may be arranged between a surface 106 of the heat-generating electronic device 50 and an adjacent surface 108 of the heat spreader 102 to facilitate the transfer of heat from the heat-generating electronic device 50 to the heat spreader 102. The surface area of the surface 108 of the heat spreader 102 facing the heat-generating electronic device 50 may be greater than, equal to, or in some embodiments, may even be smaller than the surface area of the surface 106 of the heat-generating electronic device 50.

The cooling device 100 is thermally coupled to a second, opposite surface of the heat spreader 102. In an embodiment, the second, opposite surface of the heat spreader 102 is greater than the surface of the heat-generating electronic device 50 to facilitate the transfer of heat from the heat spreader 102 to the cooling device 100. For example, the surface area of surface 108 of the heat spreader 102 may be at least 30% greater than that of the surface 106 of the heat-generating electronic device 50, and in some embodiments, is at least 40%, 50%, 60%, 70%, 80%, 90%, 100%, or more than 100% greater than the surface of the heat-generating electronic device 50. However, in other embodiments, the surface area of the second surface 110 of the heat spreader 102 may be the same or even smaller than the surface area of the heat-generating electronic device 50. In the illustrated, non-limiting embodiment, a surface 114 of the cooling device 100 is positioned directly adjacent to the heat spreader 102 and may be thermally coupled thereto via a second thermal interface material 112. It should be understood that the first thermal interface material 104 and the second thermal interface material 112 may be the same material, or alternatively, may be different. Examples of the thermal interface materials 104, 112 described herein include but are not limited to thermal adhesives, thermally conductive pads, phase change materials, solid/liquid metals, solvent-based systems, hot-melt adhesives, pressure-sensitive adhesive tapes, and thermal paste. A thermal paste may include a polymerizable liquid matrix and large volume fractions of electrically insulating, but thermally conductive filler. Typical matrix materials of a thermal paste may include epoxies, silicones (silicone grease), urethanes, and acrylates.

In an embodiment, the cooling device 100 is a heat sink configured to receive a flow of a cooling fluid. The cooling device 100 may use flow boiling of a cooling fluid C to remove heat from the heat-generating electronic device 50. During the flow boiling process, the liquid evaporates to generate a vapor phase along the flow path.

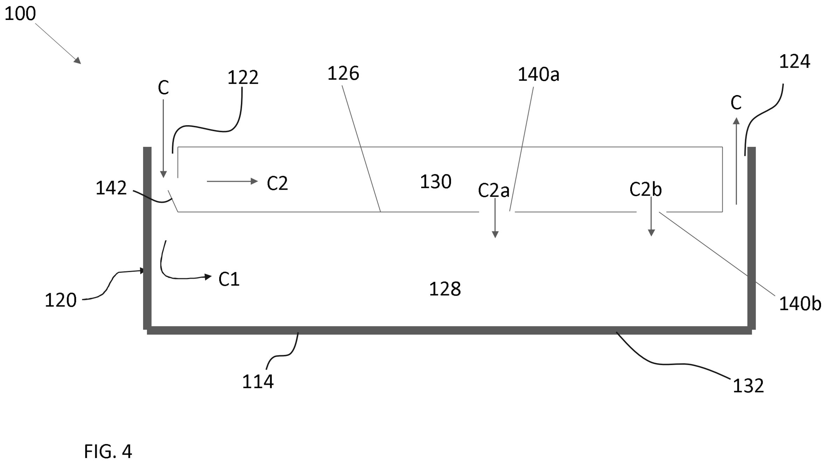

In an embodiment, the flow of the cooling fluid C within the cooling device may be controlled to prevent or reduce the occurrence of dryout, caused by the vapor phase of the cooling liquid C directly contacting the heat transfer surface 114. As shown, the cooling device 100 includes a housing 120 having a fluid inlet 122 and a fluid outlet 124. The hollow interior of the housing 120 may have at least one divider or baffle 126 arranged therein, such as extending generally between the fluid inlet 122 and the fluid outlet 124. As a result, a plurality of fluid compartments may be formed within the interior of the housing 120. In the illustrated, non-limiting embodiment, a single divider 126 is arranged within the interior such that a first fluid compartment 128 is arranged at a first side of the divider 126 and a second fluid compartment 130 is arranged at the opposite, second side of the divider 126. In the illustrated, non-limiting embodiment, the first fluid compartment 128 is arranged proximate the bottom 132 of the housing 120 and the second fluid compartment 130 is arranged near the top of the housing 120 of the cooling device 100. The bottom 132 of the housing 120 includes the surface 114 that may be mounted to the heat spreader 102. In the illustrated, non-limiting embodiment of FIGS. 3 and 4, both the first and second fluid compartment 128, 130 are fluidly connected to the fluid inlet 122; however, only the first fluid compartment 128 is directly fluidly connected to the fluid outlet 124. Although only a single divider 126 is illustrated and described herein, it should be understood that embodiments including multiple dividers and more than two fluid compartments are also within the scope of the disclosure.

One or more openings 140a, 140b may be formed in the at least one divider 126 to fluidly couple fluid compartments arranged at opposite sides thereof, such as the first fluid compartment 128 and the second fluid compartment 130. In the illustrated, non-limiting embodiment, a plurality of openings 140a, 140b are arranged at a plurality of locations over at least a portion of the length of the divider 126 extending between the fluid inlet 122 and the fluid outlet 124. The plurality of openings 140a, 140b may be substantially identical in size and/or shape, or alternatively, one or more openings 140a formed at a first position along the length of the divider 126 may have a different size and/or shape than one or more openings 140b formed at a second position along the length of the divider 126, downstream from the first position relative to a direction of flow of the cooling fluid C. This variation is size and shape may be adapted based on a desired fluid flow through the openings 140a, 140b at each location. Although openings 140a, 140b at only a first location and a second location along the length of the divider 126 are illustrated and described herein, it should be understood that embodiments including any number of openings disposed over the length of one or more dividers 126 are within the scope of the disclosure.

The cooling fluid C provided to the fluid inlet 122 of the cooling device 100 may be a cooled or subcooled liquid. As the cooling fluid C enters and/or flows through the fluid inlet 122, the cooling fluid C is separated into multiple streams or portions. In an embodiment, a first stream C1 is provided to the first fluid compartment 128 and a second stream of the cooling fluid C2 is provided to the second fluid compartment 130. The flow of cooling fluid C provided to cooling device 100 may be separated into the plurality of separate streams via any suitable manner. In an embodiment, as shown in FIG. 4, a diverter plate 142 may extend from an edge of the baffle into the pathway of the fluid inlet 122. In such embodiments, the flow of cooling fluid C arranged at a side of the diverter plate 142 is directed into the second fluid compartment. In other embodiments, at least one valve V (see FIG. 3) is arranged within the fluid inlet 122. For example, a three way valve V may be used to direct a portion of the cooling fluid toward both the first and second fluid compartments 128, 130.

As the first stream C1 of cooling fluid moves through the first fluid compartment 128, heat transfers from the bottom 132 of the housing 120 thermally coupled to the heat-generating electronic device 50 to the first stream C1 of cooling fluid. This heat transfer causes the first stream C1 of cooling fluid to rapidly vaporize. In an embodiment, a substantial entirety of the cooling fluid within the first stream C1 is vaporized at or proximate the location of the first opening 140a in the divider 126.

In an embodiment, the second fluid compartment 130 within the interior of the cooling device 100 has a reduced heat transfer potential. To achieve this reduced heat transfer potential, one or more surfaces defining the second fluid compartment 130, such as the divider 126 for example, may be formed from a material having a low coefficient of thermal conductivity with good insulation properties. Alternatively, or in addition, a liner (not shown) formed from a material having a low coefficient of thermal conductivity may be arranged at one or more surfaces of the second fluid compartment 130. For example, such materials may have a thermal conductivity between 0.001 W/m-K to 1W/m-K. Examples of a material suitable for the divider 126 and/or liner include but are not limited to ceramics, reinforced carbon-carbon composites, silica fiber tiles, insulative paints on plastics or metals, vacuum insulated panels, polyethylene aerogels, and nanofiber aerogels. Accordingly, a limited amount of heat will transfer between the first stream C1 of cooling fluid within the first fluid compartment 128 and the second stream C2 of cooling fluid within the second fluid compartment 130. As a result of this minimal heat transfer, the phase of the second stream C2 of cooling fluid within the second fluid compartment 130 remains generally constant. In some embodiments, the second stream C2 of cooling fluid is a liquid or a two phase mixture having a low concentration of vapor therein.

As the second stream C2 of cooling fluid moves through the second fluid compartment 130, the second stream C2 of cooling fluid is gradually injected into the first fluid compartment 128 via the openings 140a, 140b formed in the divider 126. As shown, a first portion C2a of the second stream C2 of cooling fluid is injected into the first fluid compartment 128 via the one or more openings 140a arranged at the first location along the length of the divider 126. A second portion C2b of the second stream C2 of cooling fluid is injected into the first fluid compartment 128via the one or more openings 140b arranged at the second location along the length of the divider 126. The resulting mixture of the first stream C1, first portion C2a of the second stream C2 and second portion C2b of the second stream C2 may then be output from the fluid outlet 124. The heat absorbed by the cooling fluid C within the cooling device 100 may then be exhausted to a secondary fluid (not shown), such as at a heat exchanger located downstream from the cooling device.

In an embodiment, the positioning of the openings 140a, 140b, and in some embodiments, the configuration of the openings 140a, 140b is selected to control the mixing of the first and second streams C1, C2 of cooling fluid to optimize the heat transfer that occurs within the first fluid compartment 128. For example, the first portion C2a of the second stream C2 of cooling fluid may be selected such that the entirety of the first portion C2a of the second stream of cooling fluid C2 mixed with the first stream C1 vaporizes at or proximate the location of the second opening 140a in the divider 126. Similarly, the second portion C2b of the second stream C2 may be selected such that the entirety of the second portion C2a of the second stream of cooling fluid C2 mixed with the first stream C1 and the first portion C2a of the second stream C2 vaporizes at or proximate the location of the fluid outlet 124.

Alternatively, or in addition, one or more openings may be formed in the divider 126 to deliver a flow of the second stream C2 of cooling fluid to the first fluid compartment 128 at a location associated with a region of the heat-generating electronic device 50 identified as a "hot spot." Injecting the second stream C2 of cooling fluid at or proximate a hot spot of the heat-generating electronic device will facilitate extra heat transfer from the heat-generating electronic device 50 to the cooling fluid within the first fluid compartment 128 at that location.

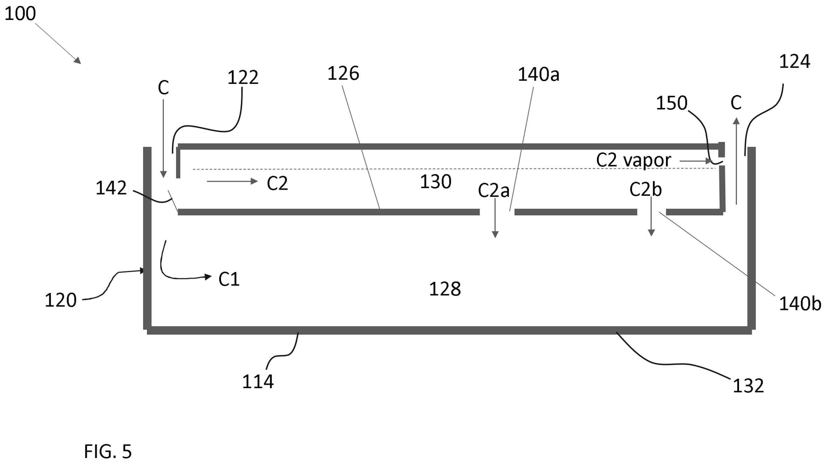

In an embodiment, such as shown in FIG. 5, the second fluid compartment 130 may be configured as a liquid-vapor separator. In such embodiments, the vapor portion of the second stream C2 of cooling fluid within the second fluid compartment 130 may accumulate near a top of the second fluid compartment 130 and the liquid portion of the second stream C2 of cooling fluid remains in contact with the first surface of the divider 126. In such embodiments, the first portion C2a and the second portion C2b of the second stream C2 of cooling fluid injected into the first fluid compartment is liquid. A bypass 150 may directly fluidly connect the upper portion of the second fluid compartment 130 to the fluid outlet 124. In such embodiments, the separated vapor portion of the second stream C2 is siphoned to the fluid outlet 124 via the bypass 150, and therefore generally bypasses any heat transfer within the cooling device 100.

A cooling device 100 as illustrated and described herein allows for controlled distribution of a cooling fluid C during a flow boiling process maintain a liquid arranged in contact with the heat transfer surface 114 of the housing 120 of the cooling device. This will reduce the potential for dryout while improve the heat transfer performance and reliability of the cooling device, while maintain a compact footprint.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention as defined by the appended claims. In addition, many modifications may be made to adapt a particular situation or material to the teachings of the present invention without departing from the scope of the invention as defined by the appended claims. Therefore, it is intended that the present invention not be limited to the particular embodiment disclosed as the best mode contemplated for carrying out this present invention, but that the present invention will include all embodiments falling within the scope of the claims.

## Claims

1. A cooling device (100) associable with a heat-generating electronic device (50) of a server (30), the cooling device comprising:
a housing (120) having a fluid inlet (122) and a fluid outlet (124);
a divider (126) separating the interior of the housing into a first fluid compartment (128) and a second fluid compartment (130), wherein both the first fluid compartment and the second fluid compartment are fluidly connected to the fluid inlet wherein a heat transfer potential of the second fluid compartment is less than the heat transfer potential of the first fluid compartment; and
at least one opening (140a, 140b) formed in the divider at a location downstream from the fluid inlet and upstream from the fluid outlet, the first fluid compartment being fluidly coupled to the second fluid compartment at the at least one opening.

2. The cooling device of claim 1, wherein the divider is formed from a material having a low coefficient of thermal conductivity.

3. The cooling device of claim 1 or claim 2, further comprising a diverter (142) arranged within the fluid inlet to separate a cooling fluid at the fluid inlet into a first stream of cooling fluid and a second stream of cooling fluid, the first stream of cooling fluid being receivable within the first fluid compartment and the second stream of cooling fluid being receivable within the second fluid compartment.

4. The cooling device according to any preceding claim, further comprising a valve arranged within the fluid inlet to separate a cooling fluid at the fluid inlet into a first stream of cooling fluid and a second stream of cooling fluid, the first stream of cooling fluid being receivable within the first fluid compartment and the second stream of cooling fluid being receivable within the second fluid compartment.

5. The cooling device of any of claims 1 to 4, wherein the first fluid compartment is directly fluidly connected to the fluid outlet.

6. The cooling device of any preceding claim, wherein the second fluid compartment is directly fluidly connected to the fluid outlet via a bypass (150) and only a portion of a cooling fluid within the second fluid compartment is receivable within the bypass, and optionally
wherein the second fluid compartment is configured as a liquid-vapor separator to separate the cooling fluid into vapor cooling fluid and liquid cooling fluid, the bypass being positioned to receive only the vapor cooling fluid.

7. The cooling device of any of the preceding claims, wherein the at least one opening includes a plurality of openings, the plurality of openings being arranged at a plurality of positions along a length of the divider between the fluid inlet and the fluid outlet, and optionally
wherein the plurality of positions includes a first position and a second position and a first portion of the plurality of openings is arranged at the first position and a second portion of the plurality of openings is arranged at the second position, wherein a configuration of the first portion of the plurality of openings is different than the configuration of the second portion of the plurality of openings.

8. The cooling device of any of the preceding claims, wherein the at least one opening includes an opening aligned with a hot spot of the heat-generating electronic device.

9. The cooling device of any of the preceding claims, wherein the housing is indirectly thermally couplable to the heat-generating electronic device by a heat spreader (102), and optionally
wherein the heat spreader is positionable vertically between the heat-generating electronic device and the cooling device.

10. A method of cooling a heat-generating electronic device (50) of a server (30), the method comprising:
delivering a flow of cooling fluid to a fluid inlet (122) of a cooling device (100);
separating the flow of cooling fluid into a first stream of cooling fluid provided to a first fluid compartment (128) within the cooling device and a second stream of cooling fluid provided to a second fluid compartment (130) within the cooling device;
transferring heat between the heat-generating electronic device and the first stream of cooling fluid; and
selectively injecting cooling fluid from the second stream of cooling fluid into the first stream of cooling fluid in the first fluid compartment at a location upstream from a fluid outlet (124) of the cooling device.

11. The method of claim 10, wherein the selectively injecting cooling fluid from the second stream of cooling fluid into the first stream of cooling fluid includes injecting cooling fluid from the second stream of cooling fluid through one or more openings (140a, 140b) formed in a divider (126) separating the first fluid compartment and the second fluid compartment, and optionally wherein the divider is formed from a material having a low coefficient of thermal conductivity.

12. The method of claim 10 or 11, wherein the selectively injecting cooling fluid from the second stream of cooling fluid into the first stream of cooling fluid includes:
injecting a first portion of the second stream of cooling fluid into the first stream of cooling fluid at a first location within the cooling device; and
injecting a second portion of the second stream of cooling fluid into the first stream of cooling fluid at a second location within the cooling device, the second location being downstream from the first location relative to the flow of cooling fluid through the cooling device.

13. The method of any of claims 10 to 12, wherein the separating the flow of cooling fluid into the first stream of cooling fluid and the second stream of cooling fluid includes positioning a diverter (142) within the fluid inlet, and/or, wherein separating the flow of cooling fluid into the first stream of cooling fluid and the second stream of cooling fluid includes operating a valve associated with the fluid inlet.

14. The method of any of claims 10 to 13, further comprising:
separating the second stream of cooling fluid into a vapor portion and a liquid portion; and
delivering the vapor portion directly to the fluid outlet via a bypass (150) fluidly connected to the second fluid compartment.

15. A server (30) comprising:
a heat-generating electronic device (50);
a cooling device (100) according to any of claims 1 to 9 thermally coupled to the heat-generating electronic device.
